(19) Europäisches Patentamt / European Patent Office / Office européen des brevets

(11) **EP 2 776 931 B1**

(12) **FASCICULE DE BREVET EUROPEEN**

(45) Date de publication et mention de la délivrance du brevet:
**07.10.2015 Bulletin 2015/41**

(21) Numéro de dépôt: **12795512.8**

(22) Date de dépôt: **09.11.2012**

(51) Int Cl.:
**G06F 11/34** *(2006.01)*    **G06F 17/50** *(2006.01)*
**G01C 22/00** *(2006.01)*

(86) Numéro de dépôt international:
**PCT/FR2012/052587**

(87) Numéro de publication internationale:
**WO 2013/068703 (16.05.2013 Gazette 2013/20)**

(54) **SYSTEME ET PROCEDE DE CONCEPTION DE CIRCUIT NUMERIQUE A CAPTEUR D'ACTIVITE, CIRCUIT NUMERIQUE CORRESPONDANT**

VORRICHTUNG UND VERFAHREN ZUM ENTWURF VON AUF EREIGNISSZÄHLUNG BASIERTE NUMERISCHE SCHALTUNGEN MIT ENTSPRECHENDE NUMERISCHE SCHALTUNG

SYSTEM AND METHOD FOR EVENT COUNTER BASED DIGITAL CIRCUIT DESIGN WITH CORRESPONDING DIGITAL CIRCUIT

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **10.11.2011 FR 1160267**

(43) Date de publication de la demande:
**17.09.2014 Bulletin 2014/38**

(73) Titulaire: **Commissariat à l'Énergie Atomique et aux Énergies Alternatives 75015 Paris (FR)**

(72) Inventeurs:
• **MANSOURI, Imen**
  **75018 Paris (FR)**
• **CLERMIDY, Fabien**
  **F-38120 Saint-Egreve (FR)**
• **BENOIT, Pascal**
  **34170 Castelnau-le-Lez (FR)**

(74) Mandataire: **Bonnet, Michel**
**Cabinet Bonnet**
**93, rue Réaumur - Boîte 10**
**75002 Paris (FR)**

(56) Documents cités:
**US-A1- 2002 133 792    US-A1- 2009 150 857**

• **JORGEN PEDDERSEN ET AL: "CLIPPER: Counter-based Low Impact Processor Power Estimation at Run-time", DESIGN AUTOMATION CONFERENCE, 2007. ASP-DAC '07. ASIA AND SOUTH P ACIFIC, IEEE, PI, 1 janvier 2007 (2007-01-01), pages 890-895, XP031085613, ISBN: 978-1-4244-0629-6**

EP 2 776 931 B1

**EP 2 776 931 B1**

## Description

La présente invention concerne un système de conception de circuit numérique à capteur d'activité. Elle concerne également un procédé mis en oeuvre par ce système, un programme d'ordinateur correspondant et un circuit numérique à capteur d'activité.

L'invention s'applique plus particulièrement à un système de conception de circuit numérique comportant :

- un simulateur d'un circuit numérique à partir d'un fichier de description fonctionnelle de ce circuit numérique,
- des moyens d'estimation d'une grandeur de sortie du circuit numérique sur exécution d'un banc de tests fourni au simulateur,
- des compteurs d'événements, les événements étant détectés à l'aide de signaux de contrôle fournis par le simulateur sur exécution du banc de tests, et
- des moyens de construction d'au moins un modèle de calcul de la grandeur de sortie du circuit numérique à partir d'une séquence de données d'estimation de cette grandeur de sortie et de données de sortie des compteurs d'événements.

Les compteurs d'événements constituent un capteur d'activité du circuit numérique simulé. Il est connu d'utiliser les données fournies par un tel capteur pour calculer, à l'aide d'un modèle à définir, une grandeur de sortie réelle dans le circuit telle qu'une puissance consommée, une température dégagée, etc. Ainsi, à partir d'une connaissance de valeurs successives de la grandeur de sortie données par simulation et de données fournies par les compteurs d'événements, il est connu de construire un modèle de calcul de cette grandeur de sortie par régression linéaire. Ce modèle peut ensuite être implémenté, à l'aide d'un moniteur (pour la capture d'activité réelle) et d'un calculateur (pour l'application du modèle) dans le circuit réel préalablement simulé. L'intérêt d'un tel calcul est de reporter l'activité du circuit en fonction des programmes implémentés et d'adapter l'effort du circuit dans des boucles de contrôle dynamiques. La sortie du modèle de calcul peut ainsi alimenter un système de régulation agissant sur la fréquence des blocs fonctionnels du circuit et leur tension d'alimentation pour optimiser la grandeur estimée.

Mais d'une façon générale, la construction d'un modèle de calcul par régression linéaire nécessite une synchronisation de la séquence de données d'estimation de la grandeur de sortie avec les données de sortie des compteurs d'événements. Pour ce faire, un échantillonnage est réalisé selon une période T prédéfinie. Une moyenne de la grandeur de sortie est alors estimée dans des fenêtres temporelles successives de durée T et les compteurs d'événements sont relevés et réinitialisés selon cette même période. Un compromis entre précision et débit du moniteur est alors à faire lors du choix de la fréquence d'échantillonnage : une fenêtre temporelle réduite assure une meilleure précision pour le modèle de calcul, en contrepartie de quoi, elle augmente le surcoût en communications engendrées par ce mécanisme du moniteur ; une fenêtre temporelle élargie permet de résoudre ce problème de débit, mais implique des compteurs d'événements plus gourmands en surface au niveau implémentation et dégrade l'information portée par chaque échantillon en raison d'un effet de moyenne.

En outre, le profil temporel de la grandeur de sortie étant généralement assez aléatoire, notamment en raison d'opérations de natures différentes réalisées par le circuit numérique, le modèle de calcul par régression linéaire nécessite un nombre de compteurs d'événements important pour être suffisamment précis et coller à la réalité, ce qui impose une complexité et une surface d'occupation minimales du capteur d'activité résultant.

D'autres solutions que des modèles dépendant uniquement des compteurs d'événements ont été recherchées, mais chaque fois avec un résultat peu satisfaisant ou avec une complexité accrue.

Ainsi, dans la demande de brevet publiée sous le numéro US 2010/0281309, il est proposé de récupérer des niveaux de tension appliqués durant l'exécution d'un programme dans le circuit numérique. La tension du circuit est ajustée en ligne par certaines instructions du programme, ou bien en fonction de la charge de travail reportée par des capteurs d'activité. Dans ce document, trois niveaux de tension « on », « off » et « maintien » sont définis. Ces niveaux sont par la suite corrélés avec les séquences du programme afin d'y identifier les points chauds et de les reconfigurer autrement. En alternative, il est proposé de mesurer la corrélation entre les séquences du programme et la sortie des capteurs d'activité, ceci permet également d'estimer les performances d'un programme et de l'optimiser avant intégration finale.

Ainsi également, dans la demande de brevet publiée sous le numéro US 2007/0276645, il est proposé une approche pour modéliser la consommation d'un circuit à un niveau d'abstraction TLM (de l'anglais « Transaction Level Modeling »). Au lieu de suivre les signaux de contrôle qui pilotent à la fois les communications et le mode d'exécution, ce document considère les messages qui circulent entre deux unités fonctionnelles différentes. Les données de simulation recueillies sont présentées sous forme d'une série de transactions associées chacune à un niveau de consommation. Ces données sont fournies à un processus d'apprentissage basé sur des réseaux de neurones pour estimer les poids du modèle. Le modèle établi permet de revoir la configuration de l'application pour une version plus optimisée, et ceci à un niveau d'abstraction élevé dans le flot de conception du circuit.

Ainsi également, dans la demande de brevet publiée sous le numéro US 2008/0301474, il est proposé d'utiliser la sortie de capteurs d'activité conjointement à un modèle prédictif pour anticiper l'évolution d'un programme en cours d'exécution sur un circuit numérique. En fonction des prédictions du modèle, la consommation du circuit est ajustée pour mieux correspondre à l'évolution de ses activités. Une table calculée en statique sert à déterminer le niveau de consommation correspondant à chaque activité. Les performances de cette approche sont pénalisées par les applications tests utilisées pour générer cette table dont la taille constitue un compromis entre précision et surface. Par ailleurs, un modèle prédictif est calculé à partir d'une auto régression linéaire sur des échantillons pris à des intervalles fixes, ce qui implique un autre compromis entre précision et débit.

La demande de brevet US 2009/0150857 A1 divulgue un système ainsi qu'une méthode de conception de circuit numérique, comportant plusieurs modes comportementaux.

Il peut être souhaité de prévoir un système de conception de circuit numérique qui permette de s'affranchir d'au moins une partie des problèmes et contraintes précités.

L'invention a donc pour objet un système de conception de circuit numérique comportant :

- un simulateur d'un circuit numérique à partir d'un fichier de description fonctionnelle de ce circuit numérique,
- des moyens d'estimation d'une grandeur de sortie du circuit numérique sur exécution d'un banc de tests fourni au simulateur,
- des compteurs d'événements, les événements étant détectés à l'aide de signaux de contrôle fournis par le simulateur sur exécution du banc de tests, et
- des moyens de construction d'au moins un modèle de calcul de la grandeur de sortie du circuit numérique à partir d'une séquence de données d'estimation de cette grandeur de sortie et de données de sortie des compteurs d'événements,

dans lequel les moyens de construction sont conçus pour attribuer une pluralité de modes possibles à la grandeur de sortie et construire un modèle de calcul de la grandeur de sortie différent pour chaque mode possible, par détermination d'un modèle de Markov à états cachés chaque état caché de ce modèle de Markov correspondant à l'un des modes possibles.

Ainsi, en dégageant plusieurs modes dans la séquence de valeurs que peut prendre la grandeur de sortie, chacun correspondant avantageusement à une statistique relativement homogène par exemple, il devient plus simple de modéliser la grandeur de sortie dans chacun de ces modes à l'aide de modèles spécifiques. Chacun de ces modèles nécessite alors moins de compteurs d'événements pour une précision donnée et, en détectant les transitions d'un mode à l'autre à l'aide de signaux de contrôle particuliers, il devient plus simple, moins coûteux et moins encombrant de calculer la grandeur de sortie en fonction des données de sortie des compteurs d'événements. Cette solution permet donc à la fois une meilleure précision des modèles et un surcoût réduit ou nul du fait que certains compteurs d'événements peuvent être omis dans les modèles en compensant leur absence par la prise en compte de différents modes.

L'invention a également pour objet un procédé de conception de circuit numérique comportant les étapes consistant à :

- simuler le fonctionnement d'un circuit numérique à partir d'un fichier de description fonctionnelle de ce circuit numérique,
- estimer une grandeur de sortie du circuit numérique sur exécution d'un banc de tests fourni en entrée de la simulation,
- compter des événements détectés à l'aide de signaux de contrôle fournis par la simulation sur exécution du banc de tests,
- construire au moins un modèle de calcul de la grandeur de sortie du circuit numérique à partir d'une séquence de données d'estimation de cette grandeur de sortie et de données de sortie de compteurs d'événements,

dans lequel la construction d'au moins un modèle de calcul de la grandeur de sortie comporte les étapes consistant à :

- attribuer une pluralité de modes possibles à la grandeur de sortie, et
- construire un modèle de calcul de la grandeur de sortie différent pour chaque mode possible, par détermination d'un modèle de Markov à états cachés chaque état caché de ce modèle de Markov correspondant à l'un des modes possibles.

De façon optionnelle, la construction d'au moins un modèle de calcul de la grandeur de sortie comporte, après avoir attribué une pluralité de modes possibles à la grandeur de sortie, les étapes consistant à :

- sectionner la séquence de données d'estimation de cette grandeur de sortie en plusieurs sous séquences, et
- associer chaque sous séquence à un unique mode parmi les modes possibles.

De façon optionnelle également, la détermination du modèle de Markov à états cachés est basée sur son optimisation par maximum de vraisemblance par rapport à la grandeur de sortie estimée par simulation et aux données de sortie des compteurs d'événements.

De façon optionnelle également, le modèle de Markov à états cachés est un modèle de type MSM dans lequel chaque état caché est associé à un modèle de calcul, à chaque instant et indépendamment d'une fréquence d'échantillonnage, de la grandeur de sortie par régression linéaire à partir d'au moins une partie des compteurs d'événements.

De façon optionnelle également, un procédé de conception de circuit numérique selon l'invention peut comporter une étape de mise en correspondance, par corrélation, des transitions d'un mode à l'autre de la grandeur de sortie avec les données de sortie d'au moins une partie des compteurs d'événements.

De façon optionnelle également, ladite partie des compteurs d'événements à partir de laquelle chaque modèle de calcul est construit pour calculer la grandeur de sortie est complémentaire, dans l'ensemble des compteurs d'événements, de ladite partie des compteurs d'événements dont les données de sortie sont mises en correspondance avec les transitions d'un mode à l'autre.

L'invention a également pour objet un programme d'ordinateur téléchargeable depuis un réseau de communication et/ou enregistré sur un support lisible par ordinateur et/ou exécutable par un processeur, comprenant des instructions pour l'exécution des étapes d'un procédé de conception de circuit numérique selon l'invention, lorsque ledit programme est exécuté sur un ordinateur.

Enfin, l'invention a également pour objet un circuit numérique à capteur d'activité comportant :

- un moniteur muni d'un capteur d'activité constitué d'une pluralité de compteurs d'événements, les événements étant détectés à l'aide de signaux de contrôle fournis par des détecteurs d'événements dans le circuit numérique, apte à fournir des données de comptage relatives aux signaux de contrôle,
- un calculateur conçu pour calculer une grandeur de sortie à partir des données de comptage fournies par le moniteur et sur la base d'au moins un modèle de calcul,

dans lequel :

- le moniteur comporte une machine à nombre fini d'états, chaque état correspondant à un mode parmi une pluralité de modes possibles de la grandeur de sortie, la machine à nombre fini d'états étant conçue pour détecter toute transition d'un mode à un autre sur la base de règles logiques appliquées à au moins une partie des signaux de contrôle, et
- le calculateur est conçu pour calculer la grandeur de sortie sur la base d'une pluralité de modèles de calcul différents, à raison d'un modèle de calcul par mode, par détermination d'un modèle de Markov à états cachés chaque état caché de ce modèle de Markov correspondant à l'un des modes possibles.

De façon optionnelle, le moniteur est conçu pour fournir des données de comptage relatives aux signaux de contrôle lorsque l'un des deux événements suivants se produit :

- au moins l'un de ses compteurs d'événements est plein,
- une transition d'un mode à un autre est détectée par la machine à nombre fini d'états.

L'invention sera mieux comprise à l'aide de la description qui va suivre, donnée uniquement à titre d'exemple et faite en se référant aux dessins annexés dans lesquels :

- la figure 1 représente schématiquement la structure générale d'un système de conception de circuit numérique selon un mode de réalisation de l'invention,
- la figure 2 illustre les étapes successives d'un premier procédé mis en oeuvre par le système de la figure 1 pour sélectionner des compteurs d'événements de circuit numérique,
- la figure 3 représente schématiquement la structure générale d'un circuit numérique conçu pour utiliser un modèle de calcul de grandeur de sortie fourni par exécution du procédé de sélection de la figure 2,
- la figure 4 illustre les étapes successives d'un second procédé mis en oeuvre par le système de la figure 1 pour construire un modèle de calcul d'une grandeur de sortie de circuit numérique à partir de compteurs d'événements déjà sélectionnés, et
- la figure 5 représente schématiquement la structure générale d'un circuit numérique conçu pour utiliser le modèle de calcul de grandeur de sortie fourni par exécution du procédé de construction de la figure 4.

La description qui va suivre comporte deux parties distinctes, indépendantes l'une de l'autre bien que pouvant être avantageusement combinées.

La première partie concerne un système et un procédé de conception de circuit numérique comportant une sélection de compteurs d'événements dont les sorties sont destinées à alimenter un modèle de calcul d'une grandeur de sortie d'un circuit numérique. Cette sélection se fait par une simulation du fonctionnement du circuit numérique sur la base d'un banc de tests et sur un critère d'optimisation d'un modèle de calcul prédéterminé. La première partie concerne également un circuit numérique utilisant le modèle de calcul optimisé pendant la sélection des compteurs d'événements pour estimer cette grandeur de sortie sans avoir besoin de la mesurer directement.

La seconde partie concerne un système et un procédé de conception de circuit numérique comportant la construction d'un modèle de calcul d'une grandeur de sortie d'un circuit numérique, ainsi qu'un circuit numérique utilisant un tel modèle de calcul pour estimer cette grandeur de sortie sans avoir besoin de la mesurer directement.

La première partie est indépendante de la seconde dans le sens où il n'est pas indispensable de construire un modèle de calcul après avoir sélectionné les compteurs d'événements : le modèle de calcul prédéterminé tel qu'optimisé en fin de première partie peut en effet suffire. La seconde partie est indépendante de la première dans le sens où la construction du modèle ne suppose pas nécessairement une sélection préalable des compteurs d'événements telle que réalisée dans la première partie : il suffit que des compteurs d'événements prédéterminés soient fournis en entrée de cette seconde partie, quelle que soit la méthode employée pour leur sélection, pour que le modèle de calcul soit construit sur la base de ces compteurs. Cependant, les deux parties peuvent être avantageusement combinées dans le sens où, après avoir sélectionné des compteurs d'événements sur la base d'un premier modèle prédéterminé et optimisable pendant la sélection, un second modèle, indépendant et différent du premier, peut être ensuite construit sur la base de ces compteurs sélectionnés. Ces opérations combinées sont réalisées par un système complet de conception de circuit numérique.

La grandeur de sortie du circuit numérique dont le calcul est souhaité est par exemple la puissance consommée à chaque instant par ce circuit. C'est cet exemple qui va être pris dans la suite de la description, mais l'invention s'applique au calcul d'autres grandeurs de sortie telles que la quantité de chaleur émise par le circuit à chaque instant ou sa température.

Première partie : sélection des compteurs d'événements par simulation du circuit numérique

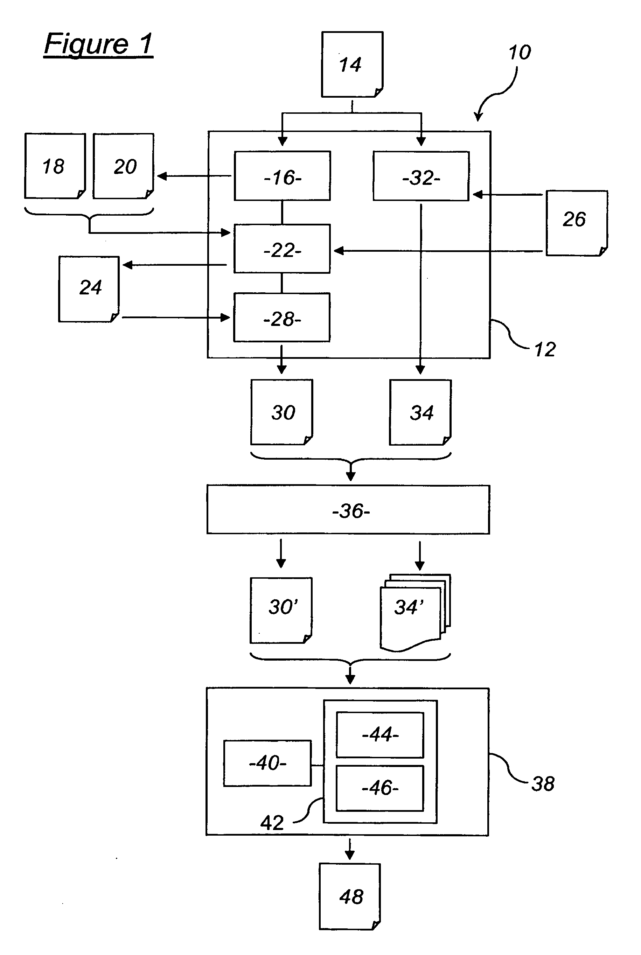

Le système 10 de conception de circuit numérique représenté sur la figure 1 comporte un simulateur 12 d'un circuit numérique à partir d'un fichier 14 de description fonctionnelle de ce circuit numérique. Le fichier 14 est plus précisément un fichier de description des blocs fonctionnels constituant le circuit numérique, par exemple conforme au format VHDL (de l'anglais « Very high speed integrated circuit Hardware Description Language »), en particulier écrit en langage synthétisable RTL (de l'anglais « Register Transfer Level »).

Le simulateur 12 comporte tout d'abord un synthétiseur hiérarchique 16 apte à créer deux fichiers de description structurelle 18 et 20 à partir du fichier de description fonctionnelle 14. Ce synthétiseur hiérarchique est par exemple l'outil Design Compiler (marque déposée). Le premier fichier de description structurelle 18 fourni par le synthétiseur hiérarchique 16 est un fichier de description des portes et connexions entre blocs fonctionnels du circuit numérique. Le second fichier de description structurelle 20 fourni par le synthétiseur hiérarchique 16, par exemple au format SDF (de l'anglais « Standard Delay Format »), est un fichier de description des délais de propagation entre les portes des blocs fonctionnels.

Le simulateur 12 comporte en outre un simulateur post-synthèse 22 apte à fournir un fichier 24 de compte-rendu d'activité, par exemple au format VCD (de l'anglais « Value Change Dump »), à partir des deux fichiers de description structurelle 18, 20 et d'un fichier 26 de banc de tests. Ce fichier 24 de compte-rendu d'activité rend plus précisément compte de l'activité de commutation des portes définies dans le premier fichier de description structurelle 18 sur exécution du banc de tests 26.

Le simulateur 12 comporte par ailleurs un simulateur 28 de sortie d'une grandeur prédéterminée. Dans cet exemple, ce simulateur 28 est un simulateur de consommation, par exemple l'outil PrimePower (marque déposée) conçu pour fournir, à partir du fichier 24 de compte-rendu d'activité, un fichier 30 de profil de la puissance consommée à chaque instant par le circuit numérique simulé sur exécution du banc de tests 26. Si d'autres grandeurs de sortie doivent être estimées (échanges thermiques, température du circuit, ...), il convient simplement d'adapter le simulateur 28 en conséquence.

Enfin, le simulateur 12 comporte un simulateur fonctionnel 32 apte à fournir un fichier 34 d'événements détectés à l'aide de signaux de contrôle fournis par des détecteurs d'événements simulés. On définit un événement portant sur un signal de contrôle, que ce signal soit binaire ou codé sur plusieurs bits, par tout passage d'un niveau à un autre dans les valeurs que peut prendre ce signal de contrôle. Il y a donc a priori autant d'événements à compter que de signaux de contrôle, ceux-ci pouvant être captés à chaque porte ou à chaque extrémité de connexion des blocs fonctionnels du circuit numérique. Les événements sont enregistrés avec une précision de delta cycle sur exécution du banc de tests 26.

Le fichier 30 de profil de puissance consommée et le fichier 34 d'événements sont fournis, en sortie du simulateur 12, à une interface 36 du système 10 de conception de circuit numérique dont la fonction principale est de synchroniser les données de ces deux fichiers, de manière à mettre en correspondance les événements détectés et l'information de puissance consommée à chaque instant, et dont une fonction optionnelle est de présélectionner les événements. La présélection consiste dans un premier temps à identifier réellement les signaux de contrôle : seuls les signaux ayant un nombre de bits inférieur à une certaine limite sont retenus, de manière à rejeter ainsi les bus de données et d'adresses. Elle consiste dans un deuxième temps à ne conserver que des signaux de contrôle indépendants. Ainsi, les signaux dupliqués, identiques mais décalés (par exemple les signaux d'entrée et de sortie d'une bascule), opposés, fournis en entrées d'amplificateurs, ... sont éliminés. Plus généralement, une intercorrélation entre signaux de contrôle peut être calculée par l'interface 36 pour ne présélectionner que ceux qui sont réellement indépendants.

Un fichier 30' de profil synchronisé de puissance consommée et une pluralité 34' de fichiers d'événements synchronisés et présélectionnés (par exemple un fichier par événement) sont fournis en sortie de l'interface 36. Les fichiers 34' forment ainsi des compteurs d'événements.

Le système 10 de conception de circuit numérique comporte en outre un module de sélection et modélisation 38. Sa première fonction est de sélectionner une partie des compteurs d'événements 34' fournis par l'interface par optimisation itérative d'un modèle de calcul de la puissance consommée du circuit numérique à partir de données de sortie des compteurs d'événements. Sa seconde fonction est de construire un modèle de calcul de la puissance consommée du circuit numérique permettant d'estimer cette consommation sans avoir besoin de la mesurer. La première fonction fait l'objet de cette première partie. La seconde fonction sera détaillée en seconde partie.

Ce module de sélection et modélisation 38 est par exemple mis en oeuvre dans un dispositif informatique tel qu'un ordinateur classique comportant un processeur 40 associé à une ou plusieurs mémoire(s) identifiée(s) par la référence générique 42. La mémoire 42 stocke un ou plusieurs programmes d'ordinateurs 44, 46 constitués de séquences d'instructions permettant, lorsqu'elles sont exécutées par le processeur 40, de réaliser les actions suivantes :

- sélectionner une partie des événements comptés, par optimisation itérative d'un modèle de calcul de la puissance consommée du circuit numérique à partir des données de comptage des événements (programme 44),
- construire un modèle de calcul de la puissance consommée du circuit numérique apte à estimer cette consommation à partir des données de comptage sélectionnées (programme 46).

On notera par ailleurs que les programmes d'ordinateurs 44, 46 sont présentés comme distincts, mais cette distinction est purement fonctionnelle. Ils pourraient tout aussi bien être regroupés en un ou plusieurs logiciels. Leurs fonctions pourraient aussi être au moins en partie micro programmées ou micro câblées dans des circuits intégrés dédiés. Ainsi, en variante, le dispositif informatique mettant en oeuvre le module de sélection et modélisation 38 pourrait être remplacé par un dispositif électronique composté uniquement de circuits numériques (sans programme d'ordinateur) pour la réalisation des mêmes actions.

On notera aussi que le simulateur 12 et l'interface 36 peuvent être mis en oeuvre par ordinateur de sorte que l'ensemble du système de conception de circuit numérique 10 peut être mis en oeuvre dans un dispositif informatique à processeur et moyens de stockage communs.

Le module de sélection et modélisation 38 fournit en sortie un enregistrement de la partie des compteurs d'événements sélectionnée et du modèle de calcul optimisé. Cet enregistrement est par exemple fourni sous la forme d'un fichier 48 exploitable lors de la fabrication du circuit numérique qui a été simulé.

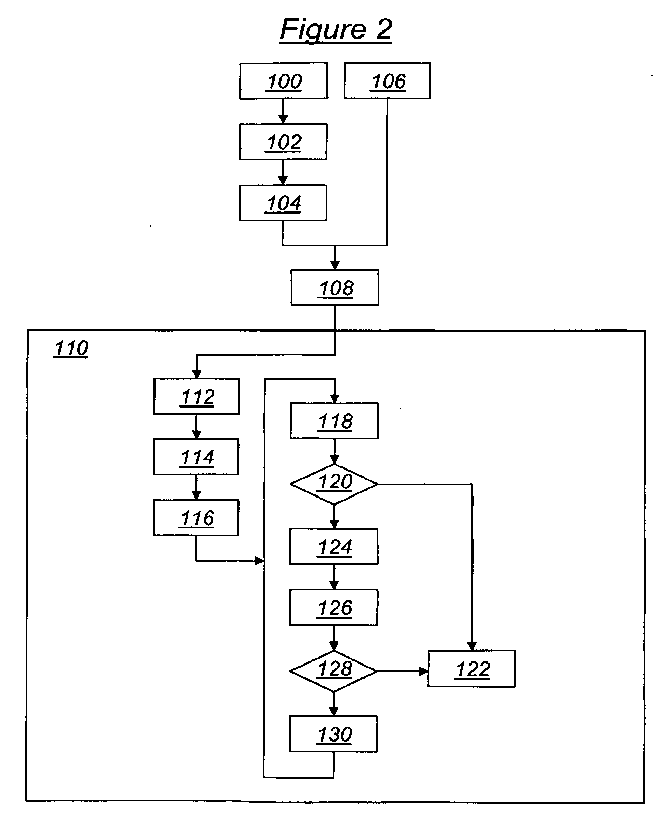

Le système 10 de conception de circuit numérique met en oeuvre un procédé tel que celui illustré sur la figure 2.

Au cours d'une première étape 100 de ce procédé, sur activation du simulateur hiérarchique 16, les deux fichiers de description structurelle 18 et 20 sont fournis à partir du fichier de description fonctionnelle 14 d'un circuit numérique donné.

Au cours d'une étape suivante 102, sur activation du simulateur post-synthèse 22, le fichier 24 de compte-rendu d'activité est fourni à partir des deux fichiers de description structurelle 18, 20 et du fichier 26 de banc de tests.

Au cours d'une étape suivante 104, sur activation du simulateur de consommation 28, le fichier 30 de profil de la puissance consommée à chaque instant par le circuit numérique simulé est fourni à partir du fichier 24 de compte-rendu d'activité.

Parallèlement aux étapes 100, 102 et 104, au cours d'une étape 106, sur activation du simulateur fonctionnel 32, le fichier 34 d'événements est fourni à partir du fichier de description fonctionnelle 14 et du fichier 26 de banc de tests.

Suite aux étapes 100, 102, 104 et 106, on passe à une étape 108 au cours de laquelle, sur activation de l'interface 36, une présélection des événements est éventuellement réalisée, pour la fourniture d'une pluralité de fichiers formant compteurs d'événements, et une synchronisation de cette pluralité de fichiers avec le fichier 30 de profil de puissance consommée est réalisée pour fournir les fichiers 30' et 34'. A cette occasion, une période d'échantillonnage T est définie pour diviser le profil de puissance consommée en une série de puissances consommées échantillonnées, chaque valeur de cette série étant la moyenne des puissances instantanées simulées dans la fenêtre de durée T correspondante. Les compteurs d'événements présélectionnés sont également échantillonnés selon cette même période T : pour chaque compteur d'événement présélectionné, une série de données de comptage est engendrée, chaque valeur de cette série étant le nombre d'événements correspondants comptés dans la fenêtre de durée T correspondante.

Ensuite un procédé 110 de sélection d'une partie des compteurs d'événements 34' est mis en oeuvre grâce à une exécution du programme 44 par le processeur 40.

Ce procédé de sélection 110 est réalisé conformément à une méthode de régression pas à pas sur la base d'un modèle prédéterminé de calcul de la puissance consommée par le circuit numérique à l'aide d'une partie des compteurs d'événements présélectionnés. Le modèle de calcul est par exemple linéaire, du type :

$$P_T = c + \alpha_1.N_{C_1} + ... + \alpha_i.N_{C_i} + ... + \alpha_n.N_{C_n} \,,$$

où :

$\{C_i\}_{i=1:n}$ est l'ensemble des compteurs d'événements participant au modèle de calcul, n caractérisant la complexité du modèle,

$N_{C_i}$ est le nombre d'événements comptés par le compteur d'événements $C_i$ dans une fenêtre de durée T,

$P_T$ est la puissance moyenne consommée dans cette même fenêtre de durée T, telle qu'elle peut être déduite des valeurs $N_{C_i}$ par le modèle de calcul,

c est la constante de régression du modèle, englobant la puissance statique du circuit numérique et un terme correctif du modèle,

$\alpha_i$ est le coefficient quantifiant la consommation partielle du circuit intégré due à l'activité détectée par le compteur d'événements $C_i$.

La constante de régression et les coefficients $\alpha_i$ sont déterminés de façon itérative par optimisation du modèle de calcul au cours de l'exécution du procédé de sélection 110, comme cela va maintenant être détaillé.

Ainsi, au cours d'une étape 112, une corrélation est calculée entre chaque série ($N_{C_i}$) et la série ($P_T$) de puissances consommées échantillonnées. La série ($N_{C_1}$) présentant la corrélation la plus élevée est sélectionnée lors de cette étape et le compteur d'événements correspondant est intégré au modèle de calcul.

Ensuite, au cours d'une étape 114, une première version notée MOD(1) du modèle de calcul de la puissance consommée, ne dépendant que de ($N_{C_1}$), est estimée par détermination de la constante de régression c et du coefficient $\alpha_1$ correspondant au compteur d'événements intégré au modèle. Cette estimation est réalisée de façon connue en soi par une méthode de minimisation des moindres carrés. Au cours de cette étape également, le coefficient de détermination ajusté $R^2$ du modèle MOD(1) est calculé. Ce coefficient $R^2$ est compris entre 0 et 1. Il permet de juger la qualité de l'ajustement du modèle MOD(1) aux mesures (i.e. les séries ($N_{C_1}$) et ($P_T$)). Il s'agit du rapport entre la quantité d'information expliquée par le modèle et le résidu d'erreur associé pondéré par la complexité du modèle. Il augmente tant que l'augmentation de complexité du modèle se justifie par une augmentation suffisante de sa qualité et baisse sinon.

L'étape 116 suivante initialise une valeur de compteur d'itérations k à 2, puis, au cours d'une étape 118, une corrélation partielle est calculée entre chaque série ($N_{C_i}$) non encore intégrée au modèle MOD(k-1) et la série ($P_T$) de puissances consommées échantillonnées. Ces corrélations partielles sont calculées en neutralisant les séries déjà intégrées au modèle MOD(k-1). Elles sont ensuite soumises, de façon classique, à un test de significativité fournissant une « valeur p » (de l'anglais « p-value ») pour chaque corrélation partielle. Cette valeur p est la probabilité de commettre une erreur de première espèce sur l'hypothèse nulle de la corrélation partielle correspondante. La série ($N_{C_k}$) présentant la valeur p Vp la plus faible est sélectionnée lors de cette étape.

Cette valeur p Vp est comparée à une première valeur p seuil VpIN au cours d'une étape de test 120. VpIN représente une valeur seuil d'entrée de compteur d'événements dans le modèle de calcul. Elle est par exemple fixée à 0,05 par défaut. Plus elle est faible, plus on limite a priori le nombre de compteurs d'événements qui seront finalement intégrés au modèle, celui-ci devenant alors plus simple mais moins précis. Si la valeur p Vp de la série ($N_{C_k}$) sélectionnée à l'étape précédente est supérieure à VpIN, on passe à une étape 122 de sortie du procédé de sélection 110.

Au cours de cette étape de sortie 122, le modèle MOD(k-1) est considéré comme modèle de calcul optimisé et est enregistré avec ses paramètres par le système de conception 10. De même, les compteurs d'événements pris en compte dans ce modèle MOD(k-1) sont définitivement considérés comme pertinents pour estimer la puissance consommée et sont enregistrés comme tels par le système de conception 10. On notera que le compteur d'événements correspondant à la dernière série ($N_{C_k}$) sélectionnée lors de l'étape 118 de l'itération courante k n'est pas intégré au modèle de calcul.

Si au contraire la valeur p Vp de la série ($N_{C_k}$) sélectionnée à l'étape 118 est inférieure à VpIN, on passe à une étape 124 de remise en cause des compteurs d'événements intégrés dans le modèle de calcul MOD(k-1). Au cours de cette étape, une nouvelle corrélation partielle est calculée entre chaque série intégrée dans le modèle MOD(k-1) et la série ($P_T$) de puissances consommées échantillonnées. Ces nouvelles corrélations partielles sont calculées en neutralisant les autres séries déjà intégrées au modèle MOD(k-1) et la série ($N_{Ck}$) dernièrement sélectionnée. Elles sont ensuite soumises, de façon classique, au test de significativité fournissant une valeur p pour chaque nouvelle corrélation partielle. L'intégration d'un nouveau compteur d'événements dans le modèle de calcul remet en effet en cause les valeurs p de tous les autres compteurs d'événements. Ainsi, toute série ($N_{Ci}$) relative à un compteur d'événements déjà intégré dans le modèle et présentant une nouvelle valeur p supérieure à une seconde valeur p seuil VpOUT, provoque la sortie du modèle du compteur correspondant. La valeur de Vp OUT est par exemple fixée à 0,1 par défaut. Elle est nécessairement supérieure à VpIN et, comme pour VpIN, plus elle est faible, plus on limite a priori le nombre de compteurs d'événements qui seront finalement intégrés au modèle.

Ensuite, au cours d'une étape 126, une nouvelle version notée MOD(k) du modèle de calcul de la puissance consommée est estimée par mise à jour de la constante de régression c et des coefficients $\alpha_i$ correspondant aux compteurs d'événements précédemment intégrés au modèle de calcul et non supprimés. Cette estimation est réalisée de façon connue en soi par une méthode de minimisation des moindres carrés. Au cours de cette même étape, le coefficient de détermination ajusté $R^2$ du modèle MOD(k) est calculé. Il permet de juger la qualité de l'ajustement du modèle MOD(k) aux mesures (i.e. les séries ($N_{Ci}$) correspondant aux compteurs d'événements sélectionnés et ($P_T$)).

Au cours d'une étape de test 128 suivante, le coefficient $R^2$ du modèle MOD(k) est comparé au coefficient $R^2$ du modèle MOD(k-1). S'il est plus faible, alors on passe à l'étape de sortie 122. Sinon, on passe à une étape 130 d'incrémentation du compteur k d'une unité puis on revient à l'étape 118 pour une nouvelle itération.

En sortie du procédé de sélection, les compteurs d'événements $C_1$, ..., $C_n$ retenus pour le modèle de calcul de la puissance consommée sont ceux du modèle MOD(k-1) pour la dernière valeur de k. Le modèle de calcul optimisé qui peut être utilisé pour une estimation de la puissance consommée par le circuit simulé est alors complètement défini par les coefficients correspondants c, $\alpha_1$, ..., $\alpha_n$.

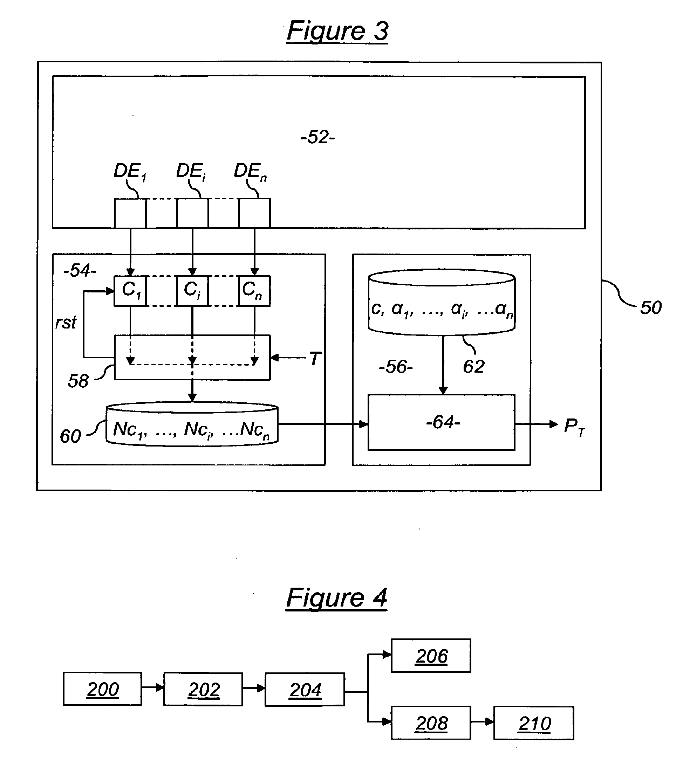

Un circuit numérique réel 52 implémentant un tel modèle de calcul de sa propre puissance consommée peut alors être conçu, comme illustré sur la figure 3. Sur cette figure, un circuit numérique 50 comporte le circuit numérique 52 préalablement simulé par le système de conception 10. Il s'agit par exemple d'un circuit de type SoC (de l'anglais « System on Chip »). Conformément à la sélection opérée par le système de conception 10, le circuit numérique préalablement simulé 52 est muni de détecteurs d'événements DE$_1$, ..., DE$_n$ relatifs aux compteurs sélectionnés lors de l'exécution du programme 44.

Le circuit numérique 50 comporte en outre un moniteur 54 et un calculateur 56 lui permettant d'utiliser le modèle de calcul optimisé pour estimer sa puissance consommée. Plus précisément, le moniteur 54 comporte des registres $C_1$, ..., $C_n$ formant les compteurs d'événements aptes à recevoir les indications d'événements fournies par les détecteurs DE$_1$, ..., DE$_n$. L'ensemble des registres forme un capteur d'activité du circuit numérique 52 préalablement simulé. Il comporte en outre un module de commande 58 conçu pour, automatiquement et à chaque période d'échantillonnage T (i.e. sous la commande d'un minuteur), lire les contenus $N_{C1}$, ..., Nc$_n$ des registres $C_1$, ..., $C_n$, transférer ces contenus Nc$_1$, ..., Nc$_n$ dans une mémoire 60 et remettre à zéro les registres $C_1$, ..., $C_1$ par envoi d'un signal rst de réinitialisation. Le calculateur 56 comporte une mémoire 62 stockant les coefficients c, $\alpha_1$, ..., $\alpha_n$ optimisés lors de l'exécution du programme 44. Il comporte en outre un processeur 64 apte à calculer à chaque période T la valeur $P_T$ de puissance consommée par le circuit numérique préalablement simulé 52 à l'aide de ces coefficients c, $\alpha_1$, ..., $\alpha_n$ stockés en mémoire 62, sur réception régulière des valeurs Nc$_1$, ..., Nc$_n$ fournies par le moniteur 54.

Un exemple concret de circuit numérique implémentant un tel modèle de calcul de sa propre puissance consommée est celui d'une RAM (de l'anglais « Random Access Memory ») dont les compteurs d'événements sélectionnés sont ceux rattachés aux signaux Chip_Select et Write_Enable. A chaque période T, les contenus de ces deux compteurs sont relevés par le module de commande 58 et fournis au calculateur 56 pour application d'un modèle de régression linéaire optimisé à trois coefficients c, $\alpha_1$ et $a_2$.

Il apparaît clairement qu'un système de conception de circuit numérique à capteur d'activité tel que celui décrit précédemment permet de réaliser une sélection automatique et efficace des compteurs d'événements avec des critères de sélection (VpIN) ou d'arrêt (VpOUT, coefficient $R^2$) paramétrables de manière à maîtriser le dimensionnement du capteur d'activité.

En outre, la méthode de régression pas à pas mise en oeuvre permet de classer les compteurs d'événements sélectionnés en fonction de leur pertinence vis-à-vis du modèle par le poids qui leur est associé. Ainsi, le choix des compteurs d'événements à retenir dans le modèle se fait en fonction de la surface disponible pour le capteur d'activité et de ce classement.

Seconde partie : modélisation de la grandeur de sortie du circuit numérique

Le système 10 de conception de circuit numérique met par ailleurs en oeuvre un procédé de construction d'un modèle de calcul d'une grandeur de sortie d'un circuit numérique tel que celui illustré sur la figure 4. Ce procédé de construction de modèle de calcul est mis en oeuvre grâce à une exécution du programme 46 par le processeur 40. Dans cet exemple également, la grandeur de sortie est la puissance consommée à chaque instant par le circuit numérique simulé sur exécution du banc de tests 26. Les données d'entrée du modèle de calcul sont celles fournies par des compteurs d'événements prédéterminés, par exemple ceux sélectionnés en première partie. Si le procédé de sélection de la première partie est mis en oeuvre, alors il est choisi une période d'échantillonnage la plus courte possible pour une meilleure précision du modèle de calcul.

Ce procédé consiste plus précisément à construire une pluralité de modèles de calcul de la puissance consommée du circuit numérique à partir d'une séquence de données d'estimation de puissance consommée, par exemple le fichier 30' de profil de puissance consommée, et de données de sortie des compteurs d'événements sélectionnés, par exemple les fichiers 34' correspondant aux compteurs sélectionnés. En particulier, il prévoit d'attribuer une pluralité de modes possibles à la puissance consommée, de sectionner le profil de puissance consommée en plusieurs séquences successives et d'associer chaque séquence à un unique mode parmi les modes possibles. Ensuite, il consiste à construire un modèle de calcul de la puissance consommée différent pour chaque mode possible.

Ce procédé de construction d'une pluralité de modèles de calcul est réalisé conformément à une méthode de détermination d'un modèle de Markov à états cachés, chaque état caché de ce modèle markovien correspondant à l'un des modes possibles. La détermination du modèle de Markov, et donc de la pluralité de modèles de calcul, est basée sur son optimisation par maximum de vraisemblance par rapport au profil de puissance consommée 30' et aux données de sortie 34' des compteurs d'événements sélectionnés.

Le modèle de Markov à états cachés est par exemple du type MSM (de l'anglais « Markov Switching Model »), tel que défini dans l'article de James D. Hamilton, intitulé « Regime-switching models », publié dans Palgrave Dictionnary of Economics, 2005. Dans ce cas, pour chaque état caché ou mode $E_j$, le modèle de calcul est par exemple linéaire et du type :

$$P(E_j) = c_j + \alpha_{1,j}.N_{C_1} + ... + \alpha_{i,j}.N_{C_i} + ... + \alpha_{n,j}.N_{C_n},$$

où :

$\{C_i\}_{i=1:n}$ est l'ensemble des compteurs d'événements sélectionnés pour participer au modèle de calcul, n caractérisant la complexité du modèle,

$N_{C_i}$ est le nombre d'événements comptés par le compteur d'événements $C_i$ dans une fenêtre de durée donnée, commune à tous les compteurs d'événements et dans laquelle est estimée la puissance consommée moyenne, mais pas nécessairement constante ou égale à la période d'échantillonnage définie en première partie,

$P(E_j)$ est la puissance moyenne consommée dans cette même fenêtre de durée donnée, telle qu'elle peut être déduite des valeurs $N_{C_i}$ par le modèle de calcul associé au mode $E_j$,

$c_j$ est la constante de régression du modèle de calcul associé au mode $E_j$, englobant la puissance statique du circuit numérique et un terme correctif du modèle,

$\alpha_{i,j}$ est le coefficient quantifiant la consommation partielle du circuit numérique due à l'activité détectée par le compteur d'événements $C_i$ lorsque que le profil de puissance consommée est conforme au mode $E_j$.

On note A la matrice de dimensions mx(n+1), où m est le nombre d'états cachés du modèle de Markov MSM, reprenant les constantes de régression et les coefficients de la pluralité de modèles :

$$A = \begin{bmatrix} c_1 & \alpha_{1,1} & ... & \alpha_{n,1} \\ ... & ... & ... & ... \\ c_m & \alpha_{1,m} & ... & \alpha_{n,m} \end{bmatrix}.$$

On suppose que le résidu d'erreur du modèle de Markov MSM est un bruit blanc gaussien de variance $\sigma$.

Enfin, on note $\Pi$ la matrice, de dimensions mxm, des probabilités de transition de chaque état ou mode Ei vers chaque état ou mode Ej :

$$\Pi = \begin{bmatrix} p_{11} & \cdots & p_{1m} \\ ... & ... & ... \\ p_{m1} & \cdots & p_{mm} \end{bmatrix}.$$

Sous ces notations, le triplet $\Theta = (A,\sigma,\Pi)$ définit complètement le modèle markovien MSM susceptible de représenter le processus P de puissance moyenne consommée à chaque instant à l'aide des données de sortie des compteurs d'événements $C_1, .... C_n$ sélectionnés. Les paramètres du modèle sont déterminés, de façon connue en soi, par une estimation du maximum de vraisemblance appliquée au triplet $\Theta=(A,\sigma,\Pi)$ au vu du profil de puissance consommée 30' et des données de sortie 34' des compteurs d'événements sélectionnés, comme cela va maintenant être détaillé en référence au procédé de construction du modèle MSM illustré sur la figure 4.

Lors d'une première étape d'initialisation 200, le nombre m d'états cachés ou modes souhaités est défini. Il peut s'agir d'une valeur paramétrable. Au cours d'une étape suivante 202, les compteurs d'événements sont initialisés et une constante leur est ajoutée pour tenir compte de la constante de régression de chaque état caché ou mode, formant ainsi un vecteur d'observation $X = (1, N_{C_1},..., N_{C_n})^T$.

Ensuite, l'estimation du maximum de vraisemblance appliquée au triplet $\Theta=(A,\sigma,\Pi)$ au vu des fichiers 30' et 34' sélectionnés est exécutée au cours d'une étape 204. Cette exécution est connue et ne sera donc pas détaillée. Il s'agit en résumé de maximiser la fonction de vraisemblance L suivante :

$$L(\Theta; P_{1:T}; X_{1:T}) = \sum_{t=1}^{T} \sum_{E} f(P_{1:T}|E_t, X_t, A, \sigma) P(S_t|\Pi),$$

Où T est le nombre d'échantillons successifs fournis par simulation, E désignant l'ensemble des états cachés ou modes.

En sortie de cette étape, une séquence des états cachés ou modes est établie au vu de la séquence de puissance consommée fournie par le fichier 30' et des observations 34'. En outre, les matrices A et n sont fournies définissant ainsi la pluralité de modèles de calcul de la puissance consommée relative à la pluralité de modes correspondants et les probabilités de transition d'un mode à l'autre.

Les étapes 200, 202 et 204 peuvent être répétées plusieurs fois avec différentes valeurs de m, permettant ainsi au final de retenir le modèle MSM dont le nombre d'états cachés est optimal par rapport aux données fournies par les fichiers 30' et 34' sélectionnés.

Suite à l'étape 204, on peut passer, de façon optionnelle mais avantageuse en termes de simplification des calculs, à une étape 206 de sélection des compteurs d'événements les plus pertinents. Sur n compteurs d'événements sélectionnés en première partie, p peuvent être retenus pour finalement participer au calcul de la puissance consommée, ceux présentant les coefficients les plus faibles dans la matrice A étant supprimés.

Suite à l'étape 204 également, des calculs classiques de corrélations permettent, lors d'une étape 208, de mettre en correspondance les transitions d'un mode à l'autre fournies en sortie de l'étape 204 avec des occurrences d'événements. Ces événements sont alors qualifiés d'événements critiques et leurs compteurs sont sélectionnés pour détecter des changements de modes de consommation. Dans un mode de réalisation envisageable et avantageux en termes de simplification des calculs, les événements critiques sont choisis parmi ceux relatifs aux n-p compteurs qui n'ont pas été sélectionnés à l'étape 206. Ainsi, la simplification du modèle due à la sélection de p compteurs participant finalement au calcul est compensée par l'utilisation des n-p autres compteurs pour détecter le plus finement possible les transitions de modes de consommation.

Suite à l'étape 208, une étape 210 consiste à établir les règles logiques de fonctionnement d'un automate fini ou machine à nombre fini d'états (i.e. les m modes) de type FSM (de l'anglais « Finite State Machine ») apte à estimer de façon déterministe les transitions de chaque mode vers chaque autre mode à partir des transitions observées sur les événements critiques. De même, cette étape de transformation des corrélations établies à l'étape 206 en règles de transitions de la machine à nombre fini d'états est à la portée de l'homme de l'art et ne sera pas détaillée.

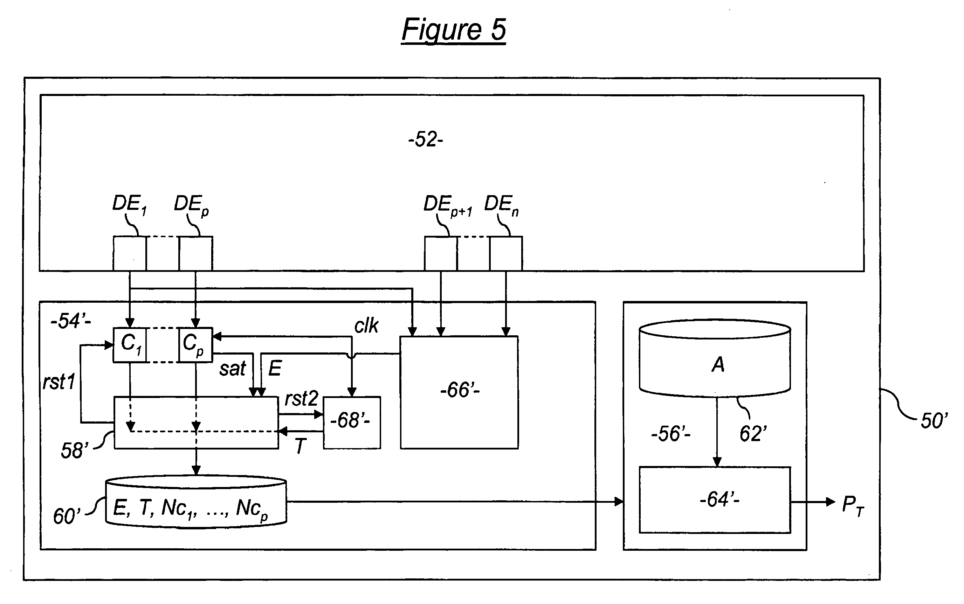

Un circuit numérique implémentant un modèle de calcul de sa propre puissance consommée sur la base du modèle markovien MSM construit par exécution du procédé de la figure 4 peut alors être conçu, comme illustré sur la figure 5.

Sur cette figure, un circuit numérique 50' comporte le circuit numérique 52 préalablement simulé par le système de conception 10. Il s'agit par exemple d'un circuit de type SoC. Conformément à la sélection opérée par le système de conception 10, le circuit numérique préalablement simulé 52 est muni de détecteurs d'événements $DE_1, ..., DE_n$ relatifs aux compteurs sélectionnés lors de l'exécution du programme 44. Le circuit numérique 50' comporte en outre un moniteur 54' et un calculateur 56' lui permettant d'utiliser le modèle de calcul markovien MSM défini précédemment pour estimer sa puissance consommée.

Plus précisément, conformément à un mode de réalisation envisageable mentionné précédemment selon lequel seuls les p premiers compteurs parmi les n compteurs sélectionnés en première partie sont sollicités pour le calcul de la puissance consommée, le moniteur 54' comporte des registres $C_1, ..., C_p$ formant ces p compteurs d'événements aptes à recevoir les indications d'événements fournies par les p premiers détecteurs $DE_1, ..., DE_p$. L'ensemble de ces registres forme un capteur d'activité du circuit numérique 52 préalablement simulé. Il comporte en outre un module de commande 58' conçu pour, automatiquement et sur des fenêtres temporelles de durées T variables, lire les

contenus $Nc_1$, ..., $Nc_p$ des registres $C_1$, ..., $C_p$, transférer ces contenus $Nc_1$, ..., $Nc_p$ dans une mémoire 60' et remettre à zéro les registres $C_1$, ..., $C_p$ par envoi d'un signal rst1 de réinitialisation.

Contrairement au mode de réalisation de la figure 3, et pour une meilleure performance du moniteur 54', ce dernier n'est pas soumis à une période d'échantillonnage fixe. Pour cela, il comporte un module 66' de machine à nombre fini d'états reproduisant les règles logiques établies à l'étape 210. Plus précisément, conformément à un mode de réalisation envisageable mentionné précédemment selon lequel seuls les n-p compteurs autres que ceux retenus pour le calcul de la puissance consommée sont sollicités pour détecter les transitions de modes de consommation, le module 66' reçoit en entrée les indications d'événements fournies par les n-p derniers détecteurs $DE_{p+1}$, ..., $DE_n$. En sortie, il fournit au module de commande 58' une indication E d'un nouveau mode de consommation du circuit numérique 52 chaque fois qu'une transition vers un tel nouveau mode E est détectée. Bien sûr, le module 66' peut aussi recevoir en entrée au moins une partie des indications d'événements fournies par les p premiers détecteurs $DE_1$, ..., $DE_p$.

Les opérations automatiques de lecture des contenus $Nc_1$, ..., $Nc_p$ des registres $C_1$, ..., $C_p$, de transfert de ces contenus dans une mémoire 60' et de remise à zéro les registres $C_1$, ...., $C_p$ sont par exemple commandées par les deux événements suivants :

- saturation d'au moins l'un des registres $C_1$, ..., $C_p$ : pour cela le module de commande 58' reçoit un signal sat d'indication de saturation dès que cet événement survient,
- changement de mode de consommation : ce changement de mode E est indiqué au module de commande 58' par le module 66'.

Ces événements n'étant pas prévisibles, le moniteur 54' comporte en outre un compteur temporel 68', soumis à une même horloge clk que celle qui synchronise les registres $C_1$, ..., $C_p$, apte à fournir la durée T qui s'est écoulée entre deux remises à zéro des registres $C_1$, ..., $C_p$. Une remise à zéro du compteur temporel 68' est réalisée par le module de commande 58' à l'aide d'un signal rst2 de réinitialisation, lors de toute remise à zéro des registres $C_1$, ..., $C_p$. Les valeurs de E et T sont alors transmises par le module de commande 58' à la mémoire 60' avec les contenus $Nc_1$, ..., $Nc_p$ des registres $C_1$, ..., $C_p$. Ainsi, la mémoire 60' stocke un historique des modes de consommation successifs, la durée de chacun de ces modes successifs et leurs données de comptage $Nc_1$, ..., $Nc_p$.

Le calculateur 56' comporte une mémoire 62' stockant les coefficients de la matrice A calculés lors de l'exécution du programme 46. Il comporte en outre un processeur 64' apte à calculer, pour chaque fenêtre temporelle de durée variable T, la valeur $P_T$ de puissance moyenne instantanée consommée par le circuit numérique préalablement simulé 52 pendant cette durée T, à l'aide des coefficients de la matrice A stockés en mémoire 62', sur réception des valeurs E, T, $Nc_1$, ..., $Nc_p$ fournies par le moniteur 54'. Il s'agit juste pour lui de sélectionner le bon modèle de régression linéaire dans la matrice A à l'aide de la valeur de E et d'en déduire la valeur de $P_T$ à l'aide des valeurs $Nc_1$, ..., $Nc_p$.

Pour reprendre l'exemple concret de la RAM dont les compteurs d'événements sélectionnés en première partie sont ceux rattachés aux signaux Chip_Select et Write_Enable, on peut appliquer un modèle markovien MSM à quatre états cachés, correspondant aux quatre modes de consommation suivants : lecture, écriture, alternance de lecture/écriture, indéterminé. Conformément au modèle markovien MSM, chacun de ces quatre modes de consommation présente son propre modèle de consommation. On montre alors que l'on peut se limiter au compteur d'événements Chip_Select pour calculer la puissance moyenne instantanée consommée par la RAM.

Par ailleurs, la machine à nombre fini d'états détectant les transitions entre les quatre modes de consommation prédéfinis peut être définie de la façon suivante, sur réception des signaux Chip_Select et Write_Enable :

- à partir du mode « lecture », on passe au mode « alternance » lorsque le signal Write_Enable passe à « 1 »,
- à partir du mode « écriture », on passe au mode « alternance » lorsque le signal Chip_Select passe à « 1 » et le signal Write_Enable à « 0 »,
- à partir du mode « alternance », on passe au mode « lecture » lorsque le nombre de lectures consécutives dépasse un nombre prédéterminé, par exemple 16,
- à partir du mode « alternance », on passe au mode « écriture » lorsque le nombre d'écritures consécutives dépasse un nombre prédéterminé, par exemple 16,
- à partir du mode « indéterminé », on passe au mode « lecture » lorsque le signal Chip_Select passe à « 1 » et le signal Write-Enable à « 0 », et
- à partir du mode « indéterminé », on passe au mode « écriture » lorsque le signal Write-Enable passe à « 1 ».

A chaque changement de mode ou saturation du registre compteur du signal Chip_Select, le contenu de ce registre est relevé par le module de commande 58' et fourni au calculateur 56' avec les valeurs de E et T pour application d'un modèle de régression linéaire optimisé à deux coefficients choisis dans la matrice A en fonction du mode de consommation détecté par la machine à quatre états.

Il apparaît clairement qu'un système de conception de circuit numérique à capteur d'activité tel que celui décrit en deuxième partie permet de construire une pluralité de modèles de calcul d'une grandeur de sortie du circuit numérique déclinable en plusieurs modes, rendant ces modèles ainsi plus précis pour un surcoût réduit ou nul du fait que certains compteurs d'événements peuvent être omis dans les modèles en compensant leur absence par la prise en compte de différents modes.

En outre, la construction de la pluralité de modèles par détermination d'un modèle de Markov à états cachés à l'aide de la maximisation d'une fonction de vraisemblance conduit à l'obtention de modèles de calcul sélectionnables à l'aide d'une machine à nombre fini d'états et indépendants d'une fréquence d'échantillonnage. Cette propriété assure davantage de flexibilité pour le capteur d'activité ainsi qu'une économie de synchronisation. En effet, la communication entre le capteur d'activité et le calculateur ne se fait plus périodiquement comme cela est généralement préconisé dans l'état de l'art, mais sur indication de transitions par la machine à nombre fini d'états ou sur saturation d'au moins un compteur du capteur d'activité.

On notera par ailleurs que l'invention n'est pas limitée aux modes de réalisation décrits précédemment. Il apparaîtra en effet à l'homme de l'art que diverses modifications peuvent être apportées aux modes de réalisation décrits ci-dessus, à la lumière de l'enseignement qui vient de lui être divulgué. Dans les revendications qui suivent, les termes utilisés ne doivent pas être interprétés comme limitant les revendications aux modes de réalisation exposés dans la présente description, mais doivent être interprétés pour y inclure tous les équivalents que les revendications visent à couvrir du fait de leur formulation et dont la prévision est à la portée de l'homme de l'art en appliquant ses connaissances générales à la mise en oeuvre de l'enseignement qui vient de lui être divulgué.

**Revendications**

1. Système (10) de conception de circuit numérique comportant :

   - un simulateur (12) d'un circuit numérique (52) à partir d'un fichier (14) de description fonctionnelle de ce circuit numérique,
   - des moyens (28) d'estimation d'une grandeur de sortie du circuit numérique sur exécution d'un banc de tests (26) fourni au simulateur (12),
   - des compteurs d'événements, les événements étant détectés à l'aide de signaux de contrôle fournis par le simulateur (12) sur exécution du banc de tests (26),
   - des moyens (40, 46) de construction d'au moins un modèle de calcul de la grandeur de sortie du circuit numérique à partir d'une séquence (30') de données d'estimation de cette grandeur de sortie et de données (34')de sortie des compteurs d'événements,

   **caractérisé en ce que** les moyens de construction (40, 46) sont conçus pour :

   - attribuer une pluralité de modes possibles à la grandeur de sortie, et
   - construire un modèle de calcul de la grandeur de sortie différent pour chaque mode possible, par détermination d'un modèle de Markov à états cachés, chaque état caché de ce modèle de Markov correspondant à l'un des modes possibles.

2. Procédé de conception de circuit numérique comportant les étapes consistant à :

   - simuler (100, 102, 104, 106) le fonctionnement d'un circuit numérique (52) à partir d'un fichier (14) de description fonctionnelle de ce circuit numérique,
   - estimer (104) une grandeur de sortie du circuit numérique sur exécution d'un banc de tests (26) fourni en entrée de la simulation,
   - compter (106) des événements détectés à l'aide de signaux de contrôle fournis par la simulation sur exécution du banc de tests (26),
   - construire au moins un modèle de calcul de la grandeur de sortie du circuit numérique à partir d'une séquence (30') de données d'estimation de cette grandeur de sortie et de données (34') de sortie de compteurs d'événements,

   **caractérisé en ce que** la construction d'au moins un modèle de calcul de la grandeur de sortie comporte les étapes consistant à :

   - attribuer (200) une pluralité de modes possibles à la grandeur de sortie, et
   - construire (202, 204) un modèle de calcul de la grandeur de sortie différent pour chaque mode possible, par détermination (204) d'un modèle de Markov à états cachés, chaque état caché de ce modèle de Markov correspondant à l'un des modes possibles.

**3.** Procédé de conception de circuit numérique selon la revendication 2, dans lequel la construction (202, 204) d'au moins un modèle de calcul de la grandeur de sortie comporte, après avoir attribué une pluralité de modes possibles à la grandeur de sortie, les étapes consistant à :

  - sectionner (204) la séquence de données d'estimation de cette grandeur de sortie en plusieurs sous séquences, et
  - associer (204) chaque sous séquence à un unique mode parmi les modes possibles.

**4.** Procédé de conception de circuit numérique selon la revendication 2 ou 3, dans lequel la détermination du modèle de Markov à états cachés est basée sur son optimisation par maximum de vraisemblance par rapport à la grandeur de sortie estimée par simulation et aux données de sortie des compteurs d'événements.

**5.** Procédé de conception de circuit numérique selon la revendication 4, dans lequel le modèle de Markov à états cachés est un modèle de type MSM dans lequel chaque état caché est associé à un modèle de calcul, à chaque instant et indépendamment d'une fréquence d'échantillonnage, de la grandeur de sortie par régression linéaire à partir d'au moins une partie des compteurs d'événements.

**6.** Procédé de conception de circuit numérique selon l'une quelconque des revendications 2 à 5, comportant une étape (208) de mise en correspondance, par corrélation, des transitions d'un mode à l'autre de la grandeur de sortie avec les données de sortie d'au moins une partie des compteurs d'événements.

**7.** Procédé de conception de circuit numérique selon les revendications 5 et 6, dans lequel ladite partie des compteurs d'événements à partir de laquelle chaque modèle de calcul est construit pour calculer la grandeur de sortie est complémentaire, dans l'ensemble des compteurs d'événements, de ladite partie des compteurs d'événements dont les données de sortie sont mises en correspondance avec les transitions d'un mode à l'autre.

**8.** Programme d'ordinateur téléchargeable depuis un réseau de communication et/ou enregistré sur un support lisible par ordinateur et/ou exécutable par un processeur, **caractérisé en ce qu'**il comprend des instructions pour l'exécution des étapes d'un procédé de conception de circuit numérique selon l'une quelconque des revendications 2 à 7, lorsque ledit programme est exécuté sur un ordinateur.

**9.** Circuit numérique (50') à capteur d'activité comportant :

  - un moniteur (54') muni d'un capteur d'activité constitué d'une pluralité de compteurs ($C_1$, .... $C_p$) d'événements, les événements étant détectés à l'aide de signaux de contrôle fournis par des détecteurs ($DE_1$, ..., $DE_p$) d'événements dans le circuit numérique, apte à fournir des données de comptage (E, T, $NC_1$, ..., $NC_p$) relatives aux signaux de contrôle,
  - un calculateur (56') conçu pour calculer une grandeur de sortie ($P_T$) à partir des données de comptage fournies par le moniteur (54') et sur la base d'au moins un modèle de calcul (A),

  **caractérisé en ce que** :

  - le moniteur (54') comporte une machine à nombre fini d'états (66'), chaque état correspondant à un mode (E) parmi une pluralité de modes possibles de la grandeur de sortie, la machine à nombre fini d'états (66') étant conçue pour détecter toute transition d'un mode à un autre sur la base de règles logiques appliquées à au moins une partie ($DE_{p+1}$, ..., $DE_n$) des signaux de contrôle, et
  - le calculateur (56') est conçu pour calculer la grandeur de sortie ($P_T$) sur la base d'une pluralité (A) de modèles de calcul différents, à raison d'un modèle de calcul par mode, cette pluralité de modèles de calcul étant stockée en mémoire (62') sous la forme d'un modèle de Markov à états cachés, chaque état caché de ce modèle de Markov correspondant à l'un des modes possibles.

**10.** Circuit numérique (50') à capteur d'activité selon la revendication 9, dans lequel le moniteur (54') est conçu pour fournir des données de comptage (E, T, $NC_1$, ..., $NC_p$) relatives aux signaux de contrôle lorsque l'un des deux événements suivants se produit :

- au moins l'un de ses compteurs d'événements ($C_1$, ..., $C_p$) est plein,
- une transition d'un mode à un autre est détectée par la machine à nombre fini d'états (66').

## Patentansprüche

1. System (10) zur Konzeption einer digitalen Schaltung, umfassend:

   - einen Simulator (12) einer digitalen Schaltung (52) auf der Grundlage einer Datei (14) zur funktionellen Beschreibung dieser digitalen Schaltung,
   - Mittel (28) zur Abschätzung einer Ausgangsgröße der digitalen Schaltung bei der Durchführung einer Testbank (26), die an den Simulator (12) geliefert wird,
   - Ereigniszähler, wobei die Ereignisse mit Hilfe von Steuersignalen nachgewiesen werden, die durch den Simulator (12) bei der Durchführung der Testbank (26) geliefert werden,
   - Mittel (40, 46) zum Aufbau von mindestens einem Modell zur Berechnung der Ausgangsgröße der digitalen Schaltung von einer Datensequenz (30') zur Abschätzung dieser Ausgangsgröße und von Ausgangsdaten (34') der Ereigniszähler,

   **dadurch gekennzeichnet, dass** die Mittel zum Aufbau (40, 46) ausgelegt sind, um:

   - der Ausgangsgröße eine Vielzahl von möglichen Modi zuzuweisen, und
   - ein Modell zur Berechnung der Ausgangsgröße, das für jeden möglichen Modus verschieden ist, durch Bestimmung eines Markov-Modells mit Cache-Zuständen aufzubauen, wobei jeder Cache-Zustand dieses Markov-Modells einem der möglichen Modi entspricht.

2. Verfahren zur Konzeption einer digitalen Schaltung, umfassend die Schritte, bestehend aus:

   - Simulieren (100, 102, 104, 106) der Funktion einer digitalen Schaltung (52) auf der Grundlage einer Datei (14) zur funktionellen Beschreibung dieser digitalen Schaltung,
   - Abschätzen (104) einer Ausgangsgröße der digitalen Schaltung bei der Durchführung einer Testbank (26), die am Eingang der Simulation geliefert wird,
   - Zählen nachgewiesenen Ereignisse (106) mit Hilfe von Steuersignalen, die durch die Simulation bei der Durchführung der Testbank (26) geliefert werden,
   - Aufbauen von mindestens einem Modell zur Berechnung der Ausgangsgröße der digitalen Schaltung von einer Datensequenz (30') zum Abschätzen dieser Ausgangsgröße und von Ausgangsdaten (34') der Ereigniszähler,

   **dadurch gekennzeichnet, dass** der Aufbau von mindestens einem Modell zur Berechnung der Ausgangsgröße die Schritte umfasst, bestehend aus:

   - Zuweisen (200) der Ausgangsgröße einer Vielzahl von möglichen Modi, und
   - Aufbauen (202, 204) eines Modells zur Berechnung der Ausgangsgröße, das für jeden möglichen Modus verschieden ist, durch Bestimmen (204) eines Markov-Modells mit Cache-Zuständen, wobei jeder Cache-Zustand dieses Markov-Modells einem der möglichen Modi entspricht.

3. Verfahren zur Konzeption einer digitalen Schaltung nach Anspruch 2, wobei der Aufbau (202, 204) von mindestens einem Modell zur Berechnung der Ausgangsgröße, nachdem der Ausgangsgröße eine Vielzahl von möglichen Modi zugewiesen wurde, die Schritte umfasst, bestehend aus:

   - Unterteilen (204) der Datensequenz zum Abschätzen dieser Ausgangsgröße in mehrere Untersequenzen, und
   - Zuordnen (204) jeder Untersequenz zu einem einzigen Modus aus den möglichen Modi.

4. Verfahren zur Konzeption einer digitalen Schaltung nach Anspruch 2 oder 3, wobei die Bestimmung des Markov-Modells mit Cache-Zuständen auf seine Optimierung durch eine maximale Ähnlichkeit mit Bezug auf die Ausgangsgröße, abgeschätzt durch Simulation, und auf Ausgangsdaten der Ereigniszähler basiert.

5. Verfahren zur Konzeption einer digitalen Schaltung nach Anspruch 4, wobei das Markov-Modell mit Cache-Zuständen ein Modell vom Typ MSM ist, in dem jeder Cache-Zustand in jedem Augenblick und unabhängig von einer Probenfrequenz mit einem Modell zur Berechnung der Ausgangsgröße durch lineare Regression ausgehend von mindestens einem Teil der Ereigniszähler assoziiert ist.

**6.** Verfahren zur Konzeption einer digitalen Schaltung nach einem der Ansprüche 2 bis 5, umfassend einen Schritt (208) zur Verbindung, durch Korrelation, der Übergänge von einem Modus in den anderen der Ausgangsgröße mit den Ausgangsdaten von mindestens einem Teil der Ereigniszähler.

**7.** Verfahren zur Konzeption einer digitalen Schaltung nach Anspruch 5 und 6, wobei der Teil der Ereigniszähler, ausgehend von dem jedes Berechnungsmodell aufgebaut ist, um die Ausgangsgröße zu berechnen, in der Einheit der Ereigniszähler komplementär zu dem Teil der Ereigniszähler ist, dessen Ausgangsdaten mit den Übergängen von einem Modus zum anderen verbunden werden.

**8.** Computerprogramm, das von einem Kommunikationsnetz herunterladbar und/oder auf einem Träger aufgezeichnet ist, der von einem Computer lesbar und/oder von einem Prozessor ausführbar ist, **dadurch gekennzeichnet, dass** er Anweisungen zur Durchführung der Schritte eines Verfahrens zur Konzeption einer digitalen Schaltung nach einem der Ansprüche 2 bis 7 umfasst, wenn das Programm auf einem Computer durchgeführt wird.

**9.** Digitale Schaltung (50') mit Aktivitätsdetektor, umfassend:

- einen Monitor (54'), ausgestattet mit einem Aktivitätsdetektor, der aus einer Vielzahl von Ereigniszählern ($C_1$, ..., $C_p$) besteht, wobei die Ereignisse mit Hilfe von Steuersignalen nachgewiesen werden, die von Ereignisdetektoren ($DE_1$, ..., $DE_p$) in der digitalen Schaltung geliefert werden, der ausgelegt ist, um Zähldaten (E, T, $NC_1$, ..., $NC_p$) mit Bezug auf die Steuersignale zu liefern,
- einen Rechner (56'), der entworfen ist, um eine Ausgangsgröße ($P_T$) ausgehend von den Zähldaten, die von dem Monitor (54') geliefert werden und auf der Grundlage von mindestens einem Berechnungsmodell (A) zu berechnen,

**dadurch gekennzeichnet, dass**:

- der Monitor (54') eine Zustandsmaschine mit einer begrenzten Anzahl von Zuständen (66') umfasst, wobei jeder Zustand einem Modus (E) aus einer Vielzahl von möglichen Modi der Ausgangsgröße umfasst, wobei die Zustandsmaschine mit einer begrenzten Anzahl von Zuständen (66') entworfen ist, um jeden Übergang von einem Modus in den anderen auf der Grundlage von logischen Regeln nachzuweisen, die mindestens auf einen Teil ($DE_{p+1}$, ...; $DE_n$) der Steuersignale angewendet werden; und
- der Rechner (56') entworfen ist, um die Ausgangsgröße ($P_T$) auf der Grundlage einer Vielzahl (A) von verschiedenen Berechnungsmodellen im Verhältnis von einem Berechnungsmodell pro Modus zu berechnen, wobei diese Vielzahl von Berechnungsmodellen im Speicher (62') in Form eines Markov-Modells mit Cache-Zuständen abgelegt ist, wobei jeder Cache-Zustand dieses Markov-Modells einem der möglichen Modi entspricht.

**10.** Digitale Schaltung (50') mit Aktivitätsdetektor nach Anspruch 9, wobei der Monitor (54') entworfen ist, um Zähldaten (E, T, $NC_1$, ..., $NC_p$) mit Bezug auf die Steuerdaten zu liefern, wenn eines der zwei folgenden Ereignisse eintritt:

- mindestens einer seiner Ereigniszähler ($C_1$, ..., $C_p$) ist voll,
- ein Übergang von einem Zustand in einen anderen durch die Zustandsmaschine mit einer begrenzten Anzahl von Zuständen (66') nachgewiesen wird.

**Claims**

**1.** System (10) for designing a digital circuit comprising:

- a digital circuit (52) simulator (12) based on a file (14) containing a functional description of this digital circuit,
- means (28) for estimating an output variable from the digital circuit when executing a test bench (26) supplied to the simulator (12),
- event counters, the events being detected using control signals provided by the simulator (12) when executing the test bench (26),
- means (40, 46) for building at least one calculation model of the digital circuit output variable based on a sequence (30') of estimation data of this output variable and output data (34') of the event counters,

**characterized in that** the building means (40, 46) are designed to:

- assign a plurality of possible modes to the output variable, and
- build a different output variable calculation model for each possible mode, by determining a hidden-state Markov model, where each hidden state in the Markov model corresponds to one of the possible modes.

2. Method for designing a digital circuit comprising the steps consisting of:

- simulating (100, 102, 104, 106) the operation of a digital circuit (52) based on a file (14) containing a functional description of this digital circuit,
- estimating (104) an output variable of the digital circuit when executing a test bench (26) supplied as input to the simulation,
- counting (106) events detected using control signals supplied by the simulation when executing the test bench (26),
- building at least one calculation model of the digital circuit output variable based on a sequence (30') of estimation data of this output variable and output data (34') from event counters,

**characterized in that** building at least one calculation model of the output variable comprises the steps consisting of:

- assigning (200) a plurality of possible modes to the output variable, and
- building (202, 204) a different output variable calculation model for each possible mode, by determining (204) a hidden-state Markov model, where each hidden state in the Markov model corresponds to one of the possible modes.

3. Method for designing a digital circuit according to claim 2, wherein building (202, 204) at least one calculation model of the output variable comprises, after assigning a plurality of possible modes to the output variable, the steps consisting of:

- splitting (204) the sequence of estimation data of this output variable into a plurality of subsequences, and
- associating (204) each subsequence with a single mode among the possible modes.

4. Method for designing a digital circuit according to claim 2 or 3, wherein the determination of the hidden-state Markov model with is based on its maximum likelihood optimization relative to the output variable estimated by simulation and the output data of the event counters.

5. Method for designing a digital circuit according to claim 4, wherein the hidden-state Markov model is an MSM type model wherein each hidden state is associated with a calculation model, at each time and independently of a sampling frequency, of the output variable using linear regression based on at least a portion of the event counters.

6. Method for designing a digital circuit according to any of claims 2 to 5, comprising a step (208) for matching, by correlation, transitions from one mode to another of the output variable with the output data of at least a portion of the event counters.

7. Method for designing a digital circuit according to claims 5 and 6, wherein said portion of the event counters based whereon each calculation model is built to calculate the output variable is complementary, in the set of event counters, to said portion of event counters wherein the output data is matched with the transitions from one mode to another.

8. Computer program that can be downloaded from a communication network and/or saved on a computer-readable medium and/or executed by a processor, **characterized in that** it comprises instructions for executing the steps of a method for designing a digital circuit according to any of claims 2 to 7, when said program is executed on a computer.

9. Digital circuit (50') having an activity sensor comprising:

- a monitor (54') with an activity sensor consisting of a plurality of event counters ($C_1$, ..., $C_p$), the events being detected using signals provided by event detectors ($DE_1$, ..., $DE_p$) in the digital circuit, suitable for providing count data (E, T, $NC_1$, ..., $NC_p$) relating to the control signals,

- a computer (56') designed to calculate an output variable ($P_T$) based on count data provided by the monitor (54') and on the basis of at least one calculation model (A),

**characterized in that**:

- the monitor (54') comprises a finite state machine (66'), each state corresponding to one mode (E) from among a plurality of possible modes of the output variable, the finite state machine (66') being designed to detect any transition from one mode to another based on logical rules applied to at least a portion ($DE_{p+1}$, ..., $DE_n$) of the control signals, and
- the computer (56') is designed to calculate the output variable ($P_T$) on the basis of a plurality (A) of different calculation models, at a rate of one calculation model per mode, said plurality of calculation models being stored in memory (62') as a hidden-state Markov model, where each hidden state in the Markov model corresponds to one of the possible modes.

10. Digital circuit (50') having an activity sensor according to claim 9, wherein the monitor (54') is designed to provide count data (E, T, $NC_1$, ..., $NC_p$) relating to the control signals when one of the following two events arises:

- at least one of the event counters ($C_1$, ..., $C_p$) thereof is full,
- a transition from one mode to another is detected by the finite state machine (66').

## Figure 1

# *Figure 2*

## Figure 3

## Figure 4

Figure 5

**EP 2 776 931 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20100281309 A
- US 20070276645 A
- US 20080301474 A
- US 20090150857 A1